# EUROPÄISCHE PATENTSCHRIFT

(11) **EP 2 649 666 B1**
(45) Veröffentlichungstag und Bekanntmachung des Hinweises auf die Patenterteilung: **30.12.2015**
(21) Anmeldenummer: 11774015.9
(22) Anmeldetag: 14.10.2011
(51) Int. Cl.: H01M 10/48, B60L 3/00, G01R 31/36, H01M 10/0525

(54) **VERFAHREN ZUR ERMITTLUNG VON BETRIEBSPARAMETERN EINER BATTERIE, BATTERIEMANAGEMENTSYSTEM UND BATTERIE**
METHOD FOR ASCERTAINING OPERATING PARAMETERS OF A BATTERY, BATTERY MANAGEMENT SYSTEM, AND BATTERY
PROCÉDÉ PERMETTANT DE DÉTERMINER DES PARAMÈTRES DE FONCTIONNEMENT D'UNE BATTERIE, SYSTÈME DE GESTION DE BATTERIE ET BATTERIE

(30) Priorität: 10.12.2010 DE 102010062856
(43) Veröffentlichungstag der Anmeldung: 16.10.2013
(73) Patentinhaber: Robert Bosch GmbH, 70469 Stuttgart (DE); SAMSUNG SDI CO., LTD., Yongin-si, Gyeonggi-do 446-577 (KR)
(72) Erfinder: BOEHM, Andre, 70806 Kornwestheim (DE); BROCHHAUS, Christoph, 52072 Aachen (DE)
(74) Vertreter: Bee, Joachim
(86) Internationale Anmeldenummer: PCT/EP2011/067948
(87) Internationale Veröffentlichungsnummer: WO 2012/076220

(56) Entgegenhaltungen:
- EP-A2- 1 933 159
- DE-T2- 60 203 171
- US-A1- 2008 150 490
- US-A1- 2010 185 405

## Beschreibung

Die vorliegende Erfindung betrifft ein Verfahren zur Ermittlung von Betriebsparametern einer Batterie, ein Batteriemanagementsystem und eine Batterie.

### Stand der Technik

In Hybrid- und Elektrofahrzeugen werden Batteriepacks in Lithium-Ionen- oder Nickel-Metallhydid-Technologie eingesetzt, die aus einer großen Anzahl von in Serie geschalteten elektrochemischen Zellen bestehen. Eine Steuerungseinheit, auch als Batteriemanagementsystem bezeichnet, dient zur Überwachung der Batterie und soll neben der Sicherheitsüberwachung eine möglichst hohe Lebensdauer gewährleisten. Dazu ist es bekannt, die Spannung jeder einzelnen Batteriezelle, den Batteriestrom und die Batterietemperatur zu messen und eine Zustandsschätzung, beispielsweise des Ladezustandes, auch als "State of Charge" (SOC) bezeichnet, und/oder des Alterungszustandes, auch als "State of Health" (SOH) bezeichnet, vorzunehmen.

Um die Lebensdauer der Batterie zu maximieren, ist es notwendig, jederzeit die aktuelle maximale Leistungsfähigkeit der Batterie beziehungsweise den zulässigen Betriebsbereich zu kennen. Der zulässige Betriebsbereich der verwendeten elektrochemischen Speicher kann beispielsweise durch einen mehrdimensionalen Raum dargestellt werden, der durch unterschiedliche Zustandsgrößen wie zum Beispiel Temperatur, Ladezustand und Stromstärke gebildet wird. Wird die Batterie in einem Arbeitspunkt (beispielsweise Temperatur, Ladezustand und Stromstärke) außerhalb des zulässigen Betriebsbereichs betrieben, also die Leistungsgrenze der Batterie überschritten, kann die Alterung der Batterie ungewollt beschleunigt werden.

Elektrochemische Energiespeicher werden bezüglich ihrer Leistungs- und Energiedichte für den jeweiligen Einsatz optimiert, das heißt, der Betriebsbereich wird in Größe und Lage den Erfordernissen beziehungsweise dem Einsatzgebiet der Batterie angepasst. Daher kann davon ausgegangen werden, dass der Energiespeicher in den Randbereichen des Betriebsbereichs auch tatsächlich an seine Leistungsgrenzen stößt, so däss eine genaue Kenntnis des aktuell zulässigen Betriebsbereichs, also der maximalen Leistungsfähigkeit, äußerst wichtig ist. Elektrochemische Energiespeicher weisen an den Grenzen des Betriebsbereichs in der Regel ein stark nichtlineares Verhalten auf.

Um den zulässigen Betriebsbereich beziehungsweise die Leistungs- und Energiewerte eines elektrochemischen Speichers in Abhängigkeit des Betriebspunkts zu bestimmen, ist es bekannt, Daten, die dem Betriebsbereich entsprechen, beispielsweise über die Temperatur, den Ladezustand und die Stromstärke, in mehrdimensionalen Tabellen zu speichern. Bei diesem Verfahren werden die gemessenen Daten des aktuellen Betriebspunkts (Spannung der Batteriezelle, Strom und Temperatur der Batterie) mit den Daten der mehrdimensionalen Tabellen verglichen und daraus der zulässige Betriebsbereich der relevanten Parameter ermittelt. Dies erfordert allerdings eine vorherige Vermessung der entsprechenden Eigenschaften einer baugleichen Batterie und setzt geringe Produktionsstreuungen voraus. Liegen jedoch signifikante Produktionsstreuungen vor oder verändert der elektrochemische Energiespeicher seine Eigenschaften im Laufe der Zeit, wird dieses Verfahren zunehmend unpräzise.

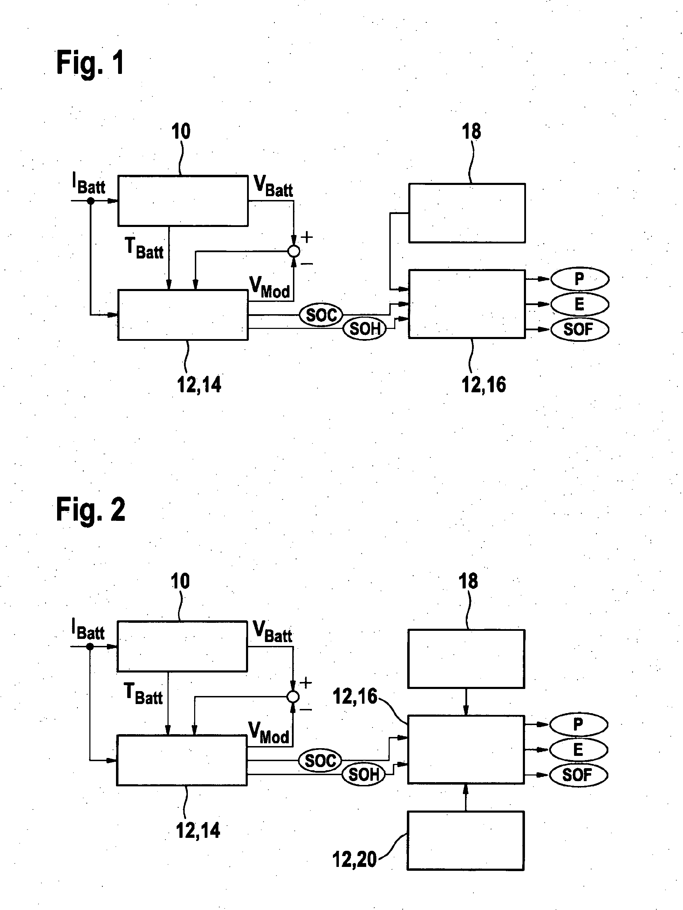

Um das genannte Problem zu adressieren, ist es weiterhin bekannt, einzelne oder eine repräsentative Auswahl der Batteriezellen mit Hilfe eines mathematischen Modells nicht nur bezüglich ihres Ladezustands SOC, sondern auch bezüglich alterungsspezifischer Parameter wie dem Alterungszustand SOH. zu untersuchen und - sofern der zulässige Betriebsbereich die gewünschten Anforderungen an die Batterie nicht zulässt - mittels einer regelungstechnischen Struktur zu beeinflussen. Eine entsprechende Anordnung ist in Figur 1 schematisch dargestellt. Dort werden die Spannung V_{Batt} der Batteriezelle 10, der Batteriestrom I_{Batt} und die Batterietemperatur T_{Batt} gemessen und eine Schätzung des Ladezustandes SOC und des Alterungszustandes SOH der Batteriezelle 10 mit Hilfe eines mathematischen Modells vorgenommen. Die Verarbeitung der gemessenen Werte V_{Batt}, I_{Batt}, T_{Batt} und die Bestimmung von SOC und SOH erfolgen über das Mittel 14 zur Bestimmung von aktuellen Betriebsparametern. Das Mittel 14 zur Bestimmung von aktuellen Betriebsparametern kann beispielsweise durch einen Mikrocontroller oder ein sonstiges Datenverarbeitungsgerät ausgebildet sein und ist Teil des Batteriemanagementsystems 12. Die vom Mittel 14 bestimmten Betriebsparameter SOC und SOH werden an das Mittel 16 zur Bestimmung beziehungsweise Vorhersage des zulässigen Betriebsbereichs der Batteriezelle 10 übergeben. Das Mittel 16 zur Bestimmung des zulässigen Betriebsbereichs kann ebenfalls durch einen Mikrocontroller oder ein sonstiges Datenverarbeitungsgerät ausgebildet sein und ist ebenfalls Teil des Batteriemanagementsystems 12. Durch das Mittel 16 kann mit Hilfe der bestimmten zellspezifischen Parameter SOC und SOH eine modellbasierte Vorhersage der Leistungsparameter (das heißt der zulässigen Betriebsbedingungen) vorgenommen werden. Weiterhin können die durch das Mittel 16 bestimmten, zulässigen Betriebsbedingungen mit den tatsächlich zu erwartenden Anforderungen an die Batterie verglichen werden, die vom Mittel 18 zur Vorhersage von geforderten Betriebseigenschaften der Batterie 10 geliefert werden. Anhand der geforderten Betriebseigenschaften und der zulässigen Betriebsbedingungen können Parameter für den tatsächlichen Betrieb der Batterie innerhalb der zulässigen Betriebsbedingungen generiert werden, beispielsweise die Entladeleistung P, die entnehmbare Energie E sowie die Leistungsfähigkeit, auch als "starte of Function" (SOF) bezeichnet. Diese Parameter steuern dann den Betriebspunkt der Batterie 10.

Dabei verwenden die Mittel 14 und 16 vorzugsweise das gleiche mathematische Modell mit identischen Parametern SOC und SOH. Damit kann auf vorab vermessene und ermittelte Leistungstabellen verzichtet werden. Das Verhalten von elektrochemischen Energiespeichern kann in Teilen des Betriebsbereichs vereinfacht als linear angesehen und daher durch lineare Modelle nachgebildet werden. Lineare mathematische Modelle zur Bestimmung von Betriebsparametern sind beispielsweise das Shepherd-Modell, das Unnewehr-Modell oder das aus DE 602 03 171 T2 bekannte Verfahren.

So ist aus der EP 1 933 159 A2 bekannt, mathematische Modelle in Batterien zu verwenden. US 2010/185405 A1 offenbart die Verwendung von unterschiedlichen Tabellen zur Widerstandsberechnung von Batterien in unterschiedlichen Temperaturbereichen. US 2008/150490 A1 eine Steuerung des Ladungszustands einer Batterie unter Verwendung eines Ladungszustandsmodells.

In denjenigen Teilen des Betriebsbereichs, in der Regel in den Randzonen, in denen das Verhalten nichtlinear wird, kann nur mit großem Aufwand ein Modell zur Beschreibung des Verhaltens gefunden werden. Solche Modelle zeichnen sich in der Regel durch hohe Komplexität und eine hohe Anzahl von Parametern aus. Nichtlineare mathematische Modelle zur Bestimmung von Betriebsparametern sind beispielsweise das Nernst-Modell oder das Plett-Modell.

### Offenbarung der Erfindung

Die Erfindung dient zur Verbesserung der Vorhersage von Leistungsdaten von Batterien, insbesondere dem zulässigen Betriebsbereich von Betriebsparametern einer Batterie, die nach den im Stand der Technik bekannten Verfahren Einschränkungen und Ungenauigkeiten, insbesondere durch Produktionsstreuungen und Alterung unterworfen sind.

Das erfindungsgemäße Verfahren zur Ermittlung von Betriebsparametern einer Batterie umfasst folgende Schritte:
- Messen von Betriebsparametern der Batterie,
- Bestimmen weiterer relevanter Betriebsparameter der Batterie aus den gemessenen Betriebsparametern,
- Vergleich mindestens eines der bestimmten Betriebsparameter mit einem vordefinierten Vergleichsintervall,
- Bestimmen eines zulässigen Betriebsbereichs des mindestens einen Betriebsparameters allein anhand eines mathematischen Batteriemodells, sofern der mindestens eine Betriebsparameter innerhalb des vordefinierten Vergleichsintervalls liegt, oder Bestimmen eines zulässigen Betriebsbereichs des mindestens einen Betriebsparameters allein anhand abgespeicherter Batteriedaten, sofern der mindestens eine Betriebsparameter außerhalb des vordefinierten Vergleichsintervalls liegt.

Das erfindungsgemäße Verfahren bietet den Vorteil, dass innerhalb des vordefinierten Vergleichsintervalls ein vorzugsweise lineares mathematisches Batteriemodell mit geringer Komplexität und wenig freien Parametern vorteilhaft verwendet werden kann, während im nichtlinearen Betriebsbereich der Batterie, der sich außerhalb des vordefinierten Vergleichsintervalls befindet, auf abgespeicherte Batteriedaten zurückgegriffen wird, die eine höhere Genauigkeit zur Vorhersage der Leistungsdaten bieten. Dies ist insbesondere vorteilhaft, da das (lineare) mathematische Batteriemodell sowohl Produktionsstreuungen als auch Alterungserscheinungen von Batterien im linearen Betriebsbereich besser berücksichtigen kann.

Die Vorteile sind eine präzise Prädiktion aller relevanten Leistungsdaten wie zum Beispiel Lade- und Entladeleistung, verfügbare Energie, entnehmbare Energie, Spannungsgrenzen, Terriperaturgrenzen, Stromgrenzen, kundenspezifischer Funktionen und/oder Kennwerte auch in den Randzonen des Betriebsbereiches sowie eine Alterungsnachführung der Leistungsdaten auch unter Berücksichtigung von Produktionsstreuungen.

Das erfindungsgemäße Verfahren basiert auf der Beobachtung des elektrochemischen Energiespeichers mittels eines linearen Modells in den Teilen des Betriebsbereiches, in dem der Energiespeicher ein lineares Verhalten oder im Wesentlichen lineares Verhalten zeigt. In den nichtlinearen Teilen des Betriebsbereiches werden die Parameter dieses Modells hingegen nicht unter Zuhilfenahme des Batteriemodells angepasst.

Vorzugsweise wird das Bestimmen eines zulässigen Betriebsbereichs des mindestens einen Betriebsparameters innerhalb eines vorgegebenen Zeitintervalls wiederholt. In einer bevorzugten Ausführungsvariante werden die zulässigen Betriebsparameter innerhalb eines Zeitintervalls von kleiner als 10 min, bevorzugter kleiner als 1 min, noch bevorzugter kleiner als 10 s und noch bevorzugter kleiner als 1 s wiederholt. Dadurch wird gewährleistet, dass eine permanente Vorhersage des zulässigen Betriebsbereichs aller relevanten Betriebsparameter erfolgt. Dadurch kann gewährleistet werden, dass die Leistungsgrenze der Batterie nicht überschritten und entsprechend die Alterung der Batterie nicht ungewollt beschleunigt wird.

Vorzugsweise ist das mathematische Batteriemodell ein lineares mathematisches Batteriemodell.

Vorzugsweise wird ein Vergleich des bestimmten zulässigen Betriebsbereichs des mindestens einen Betriebsparameters mit einem zukünftigen Betriebsanforderungsprofil (an die Batterie) vorgenommen. Mit anderen Worten wird verglichen, ob der geforderte Arbeitspunkt (auch Betriebspunkt) der Batterie innerhalb des permanent bestimmten zulässigen Betriebsbereichs liegt. Ist dies der Fall, kann die Batterie gemäß dem Betriebsanforderungsprofil, das heißt, bei dem geforderten Arbeitspunkt betrieben werden. Ergibt der Vergleich hingegen, dass der geforderte Arbeitspunkt außerhalb des aktuell bestimmten zulässigen Betriebsbereichs liegt, ist es vorgesehen, die Batterie nicht gemäß dem Betriebsanforderungsprofil, das heißt bei dem geforderten Arbeitspunkt, sondern innerhalb des zulässigen Betriebsbereichs zu betreiben. Vorzugsweise wird die Batterie bei demjenigen Grenzwert des zulässigen Betriebsbereichs (Leistung, Energieform, Temperatur...) betrieben, der dem Arbeitspunkt des Betriebsanforderungsprofils am nächsten kommt.

Die Grenzen des linearen Teilbereichs (das heißt des vordefinierten Vergleichsintervalls) können fest vorgegeben werden. Vorzugsweise wird das vordefinierte Vergleichsintervall jedoch anhand der gemessenen Betriebsparameter bestimmt. In einer bevorzugten Ausführungsvariante des Verfahrens können diese Grenzen (des vordefinierten Vergleichsintervalls) durch geeignete Algorithmen während des Betriebs bestimmt und angepasst werden.

Vorzugsweise werden Tabellen - die so genannten abgespeicherten Batteriedaten - zur Beschreibung und Prädiktion des Verhaltens über dem gesamten Betriebsbereich, dem linearen und dem nichtlinearen Teil (vorzugsweise empirisch) ermittelt und hinterlegt. Anstatt der Speicherung der durch Vermessung ermittelten empirischen Verhaltensdaten in Tabellen können ebenso mathematische Beschreibungen des Verhaltens in Abhängigkeit der Betriebsparameter gewählt werden.

Vorzugsweise wird ein Abgleich zwischen den abgespeicherten Batteriedaten und dem mathematischen Batteriemodell vorgenommen.

Dieser Abgleich kann zum Beispiel anhand geeigneter Stützstellen im Betriebsbereich vollzogen werden. Dabei können zum Beispiel die empirischen Daten mittels geeigneter Gewichtungsfaktoren an die modellbasiert ermittelten Eigenschaften angepasst werden.

In einer bevorzugten Ausführungsvariante ist es vorgesehen, die abgespeicherten Batteriedaten (im nichtlinearen Teilbereich) um eine mit Hilfe des mathematischen Batteriemodells ermittelte Alterung der Batteriezellen zu modifizieren. Weiterhin ist es bevorzugt, die mit Hilfe des mathematischen Batteriemodells ermittelte Alterung unter Verwendung von Gewichtungsfaktoren bei der Modifizierung der abgespeicherten Batteriedaten zu berücksichtigen. Vorzugsweise, werden die Gewichtungsfaktoren anhand des Betrages der Differenz zwischen abgespeicherten Betriebsparametern und mit Hilfe des mathematischen Batteriemodells ermittelten Betriebsparametern bestimmt.

Durch den Abgleich des prädizierten Verhaltens aufgrund der abgespeicherten Batteriedaten und aufgrund des mathematischen Batteriemodells kann sowohl der Einfluss der Produktionsstreuung als auch die Alterung des Energiespeichers berücksichtigt werden.

In einer bevorzugten Variation des Verfahrens können für den Fall, dass die Ausprägung des nichtlinearen Verhaltens ebenfalls von Alterung und/oder Streuung ablängt, ein oder mehrere weitere Skalierungsfaktoren vorgesehen werden, die diese Ausprägung der Nichtlinearität beschreiben und mittels geeigneter Beobachtungsverfahren nachgeführt werden. Die abgespeicherten Batteriedaten, die zur Bestimmung des zulässigen Betriebsbereichs des mindestens einen Betriebsparameters im nichtlinearen Bereich herangezogen werden, werden dann entsprechend der Ergebnisse der Beobachtung der Alterung und/oder Streuung, das heißt mittels der Skalierungsfaktoren modifiziert.

Weiterhin wird ein Batteriemanagementsystem offenbart, umfassend: Mittel zum Messen von Betriebsparametern der Batterie, Mittel zum Bestimmen weiterer Betriebsparameter der Batterie aus den gemessenen Betriebsparametern, einen Speicher, in dem (vorzugsweise empirisch bestimmte) Batteriedaten einer Batterie über den Betriebsbereich abgespeichert sind; wobei das Batteriemanagementsystem ausgebildet ist, mindestens einen der bestimmten Betriebsparameter mit einem vordefinierten Vergleichsintervall zu vergleichen, und wobei der zulässige Betriebsbereich des mindestens einen Betriebsparameters anhand eines mathematischen Batteriemodells bestimmt wird, sofern der mindestens eine Betriebsparameter innerhalb des vordefinierten Vergleichsintervalls liegt oder der zulässige Betriebsbereich des mindestens einen Betriebsparameters anhand abgespeicherter Batteriedaten bestimmt wird, sofern der mindestens eine Betriebsparameter außerhalb des vordefinierten Vergleichsintervalls liegt.

Weiterhin wird eine Batterie, vorzugsweise eine Lithium-Ionen-Batterie, mit dem erfindungsgemäßen Batteriemanagementsystem offenbart. Die erfindungsgemäße Batterie ist insbesondere ausgebildet, das erfindungsgemäße Verfahren auszuführen.

Weiterhin wird ein Kraftfahrzeug mit der erfindungsgemäßen Batterie offenbart, wobei die Batterie vorzugsweise mit einem Antriebssystem des Kraftfahrzeuges verbunden ist.

Weitere vorteilhafte Weiterbildungen der Erfindung sind in den Unteransprüchen angegeben und in der Beschreibung beschrieben.

### Zeichnungen

Ausführungsbeispiele der Erfindung werden anhand der Zeichnungen und der nachfolgenden Beschreibung näher erläutert. Es zeigen:
Figur 1 ein konventionelles Batteriemanagementsystem nach dem Stand der Technik,
Figur 2 ein erfindungsgemäßes Batteriemanagementsystem,
Figur 3 ein Blockschaltbild zur Bestimmung des zulässigen Betriebsbereichs von Betriebsparametern gemäß einer ersten Ausführungsvariante des erfindungsgemäßen Verfahrens,
Figur 4 ein Blockschaltbild zur Bestimmung des zulässigen Betriebsbereichs von Betriebsparametern gemäß einer zweiten Ausführungsvariante des erfindungsgemäßen Verfahrens, und
Figur 5 ein Blockschaltbild zur Bestimmung des zulässigen Betriebsbereichs von Betriebsparametern gemäß einer dritten Ausführungsvariante des erfindungsgemäßen Verfahrens.

### Ausführungsformen der Erfindung

In der Figur 2 ist ein erfindungsgemäßes Batteriemanagementsystem 12 gezeigt. Das Batteriemanagementsystem 12 weist Mittel zum Messen von Betriebsparametern, beispielsweise der Batteriespannung V_{Batt}, des Batteriestroms I_{Batt} und der Temperatur T_{Batt} der Batterie 10 auf. Die Batteriespannung V_{Batt} wird im vorliegenden Ausführungsbeispiel über eine Vergleichsspannung V_{MOD} gemessen. Weiterhin ist ein Mittel 14 zur Bestimmung von aktuellen Betriebsparametern wie dem SOC und dem SOH vorgesehen. Die bestimmten Betriebsparameter SOC und SOH werden an das Mittel 16 zur Vorhersage des zulässigen Betriebsbereichs der Batterie 10 übergeben. Das Batteriemanagementsystem 12 verfügt weiterhin über einen Speicher 20, in dem der zulässige Betriebsbereich der Betriebsparameter (beispielsweise Spannung, Temperatur, Strom, Entladeleistung, entnehmbare Energie ...) der verwendeten Batterie 10 durch einen mehrdimensionalen Raum beziehungsweise in mehrdimensionalen Tabellen dargestellt ist. Im Speicher 20 werden also zulässige Betriebsbereiche für unterschiedliche Zustandsgrößen wie beispielsweise Temperatur, SOC, SOH und Stromstärke, jeweils in Abhängigkeit der anderen Betriebsparameter gespeichert. Weiterhin ist ein Mittel 18 zur Vorhersage von geforderten Betriebseigenschaften der Batterie 10 vorhanden. Das erfindungsgemäße Batteriemanagementsystem 12 ist ausgebildet, anhand der ermittelten Betriebsparameter wie SOC und SOH eine Vorhersage über den zulässigen Betriebsbereich der relevanten Betriebsparameter (beispielsweise Entladeleistung oder entnehmbare Energie) zu generieren. Erfindungsgemäß werden die Betriebsparameter innerhalb eines vordefinierten Vergleichsintervalls, in dem das Verhalten der Batterie 10 vereinfacht als linear angesehen werden kann, anhand eines mathematischen Batteriemodellsbestimmt, wohingegen die Betriebsparameter im nichtlinearen Betriebsbereich, der sich außerhalb eines vordefinierten Vergleichsintervalls befindet, mit Hilfe abgespeicherter Batteriedaten des Speichers 20 bestimmt werden. Mit anderen Worten, das Mittel 16 zur Vorhersage des zulässigen Betriebsbereichs der Batterie 10 ist ausgebildet, den zulässigen Betriebsbereich der jeweiligen relevanten Betriebsparameter anhand eines mathematischen Batteriemodells zu bestimmen, sofern sich diese Betriebsparameter in einem Bereich befinden, im dem das vorzugsweise lineare mathematische Batteriemodell eine hohe Genauigkeit aufweist, insbesondere weil Alterung und Produktionsstreuungen berücksichtigt werden können. Darüber hinaus ist das Mittel 16 zur Vorhersage des zulässigen Betriebsbereichs der Batterie 10 ausgebildet, den zulässigen Betriebsbereich der jeweiligen relevanten Betriebsparameter wie anhand von im Speicher 20 abgespeicherten Batteriedaten zu bestimmen, sofern sich diese Betriebsparameter in einem Bereich befinden, in dem das mathematisches Batteriemodell aufgrund des anzunehmenden nichtlinearen Verhaltens der Batterie 10 eine geringe Genauigkeit aufweisen würde.

Nach Bestimmung der zulässigen Betriebsparameter wird ein Vergleich der tatsächlich an die Batterie 10 gestellten Anforderungen mit dem zulässigen Betriebsbereich (Summe der zulässigen Betriebsparameter) vorgenommen, wobei die tatsächlich gestellten Anforderungen vom Mittel 18 zur Vorhersage von geforderten Betriebseigenschaften der Batterie 10 übergeben werden. Sofern die tatsächlich gestellten Anforderungen der einzelnen Betriebsparameter innerhalb des vorher bestimmten, zulässigen Bereichs liegen, kann die Batterie 10 gemäß den tatsächlich gestellten Anforderungen betrieben werden, da sie nicht an ihre Leistungsgrenzen gerät. Ergibt der Vergleich hingegen, dass der geforderte Arbeitspunkt außerhalb des aktuell bestimmten zulässigen Betriebsbereichs liegt, ist es vorgesehen, die Batterie 10 nicht gemäß dem Betriebsanforderungsprofil, das heißt bei dem geforderten Arbeitspunkt, sondern innerhalb des zuvor bestimmten zulässigen Betriebsbereichs zu betreiben. Vorzugsweise wird die Batterie 10 bei dem Grenzwert des zulässigen Betriebsbereichs betrieben, der dem Arbeitspunkt des Betriebsanforderungsprofils am nächsten kommt. Die entsprechenden Leistungsparameter für die Batterie 10 wie beispielsweise Leistung P, Energie E und State of Function SOF werden dann entsprechend modifiziert.

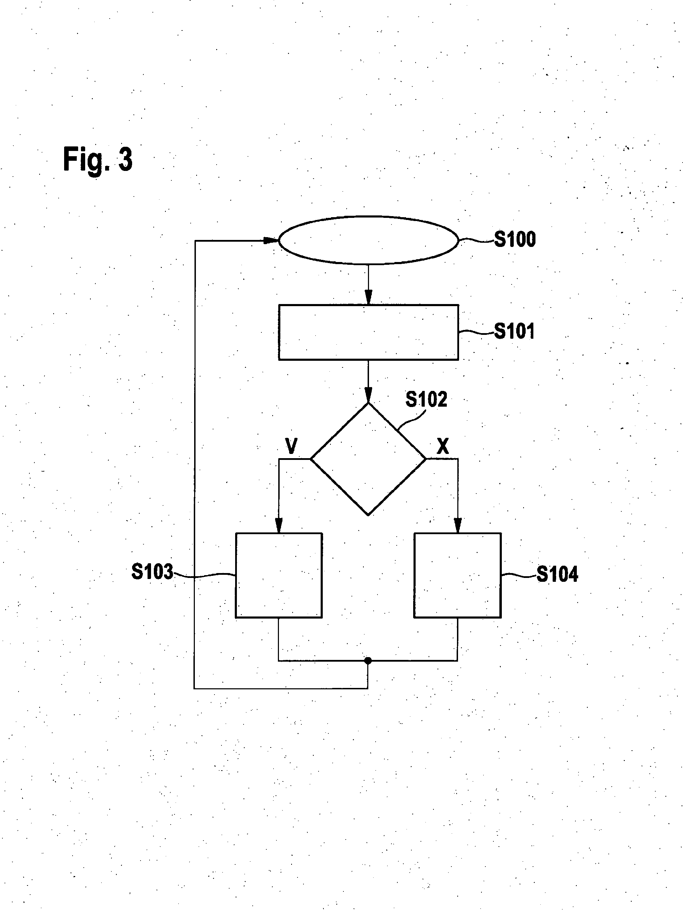

Figur 3 zeigt ein Blockschaltbild zur Bestimmung des zulässigen Betriebsbereichs von Betriebsparametern gemäß einer ersten Ausführungsvariante des erfindungsgemäßen Verfahrens.

Im Verfahrensschritt S100 werden zunächst Betriebsparameter, beispielsweise die Batteriespannung V_{Batt}, der Batteriestrom I_{Batt} und die Temperatur T_{Batt} der Batterie 10 gemessen. In der Regel handelt es sich um eine Lithium-Ionen-Batterie, bei der eine Vielzahl von Batteriezelle in Reihe und/oder parallel geschaltet sind. In einem solchen Fall wird regelmäßig die Spannung jeder einzelnen Batteriezelle gemessen.

Nachfolgend werden im Verfahrensschritt S101 relevante Betriebsparameter wie SOC und SOH der Batterie 10 aus den gemessenen Betriebsparametern V_{Batt}, I_{Batt}, T_{Batt} bestimmt. Weitere relevante Betriebsparameter sind beispielsweise Lade- und Entladeleistung, verfügbare Energie, entnehmbare Energie, Spannungsgrenzen, Temperaturgrenzen, Stromgrenzen sowie andere kundenspezifische Funktionen und/oder Kennwerte..

Um eine übermäßige Alterung der Batterie 10 zu vermeiden, ist es notwendig, permanent den zulässigen Betriebsbereich der relevanten Betriebsparameter, das heißt die Leistungsgrenzen zu bestimmen, außerhalb derer die Batterie 10 nicht betrieben werden soll.

Um erfindungsgemäß eine einfache und gleichzeitig zuverlässige Vorhersage über den zulässigen Betriebsbereich der relevanten Betriebsparameter treffen zu können, wird zunächst in Verfahrensschritt S102 untersucht, ob sich die im Verfahrensschritt S101 bestimmten Betriebsparameter innerhalb eines vordefinierten Vergleichsintervalls befinden, in dem das Verhalten der Batterie 10 vereinfacht als linear angesehen werden kann.

Ist dies der Fall, wird der zulässige Betriebsbereich der relevanten Betriebsparameter in Verfahrensschritt S103 anhand eines linearen mathematischen Batteriemodells bestimmt. Befindet sich jedoch mindestens einer der relevanten Betriebsparameter außerhalb des vordefinierten Vergleichsintervalls und muss entsprechend angenommen werden, dass das Verhalten der Batterie 10 nicht vereinfacht als linear angesehen werden kann, wird der zulässige Betriebsbereich der relevanten Betriebsparameter in Verfahrensschritt S104 anhand von vorab im Speicher 20 hinterlegten Batteriedaten bestimmt.

Es ist insbesondere vorteilhaft, für diesen Bereich außerhalb des vordefinierten Vergleichsintervalls auf die Verwendung eines komplexen, nichtlinearen mathematischen Batteriemodells zu verzichten und auf entsprechende Tabellen (das heißt hinterlegte Batteriedaten) zurückzugreifen.

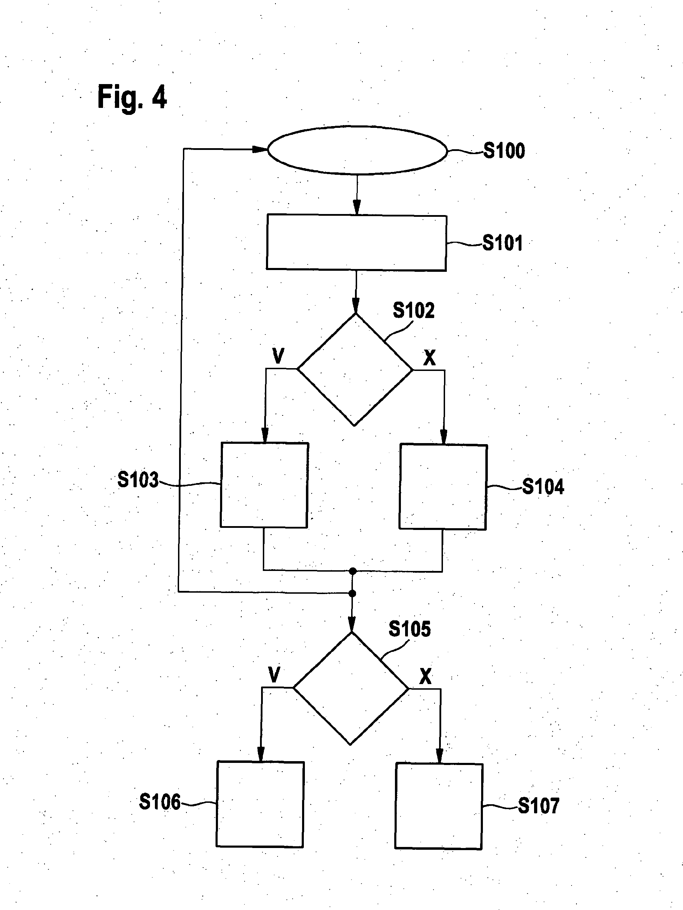

Figur 4 zeigt ein Blockschaltbild zur Bestimmung des zulässigen Betriebsbereichs von Betriebsparametern gemäß einer zweiten Ausführungsvariante des erfindungsgemäßen Verfahrens, die eine Weiterbildung des in Figur 3 gezeigten Verfahrens darstellt.

Die gemäß dem Verfahren der Figur 3 bestimmten zulässigen Betriebsbereiche der relevanten Betriebsparameter, wie beispielsweise Lade- und Entladeleistung, verfügbare Energie, entnehmbare Energie, Spannungsgrenzen, Temperatur- und Stromgrenzen, können nun in Verfahrensschritt S105 mit den tatsächlich an die Batterie 10 gestellten Anforderungen verglichen werden.

Sofern die tatsächlich gestellten Anforderungen der einzelnen Betriebsparameter innerhalb der vorher bestimmten, zulässigen Bereiche liegen, kann die Batterie 10 in Verfahrensschritt S106 gemäß den tatsächlich gestellten Anforderungen betrieben werden, da sie nicht an ihre Leistungsgrenzen gerät. Ergibt der Vergleich hingegen, dass der geforderte Arbeitspunkt außerhalb des aktuell bestimmten zulässigen Betriebsbereichs liegt, ist es vorgesehen, die Batterie 10 nicht gemäß dem tatsächlich gestellten Betriebsanforderungsprofil, das heißt bei dem geforderten Arbeitspunkt, sondern in Verfahrensschritt S107 innerhalb des zuvor bestimmten zulässigen Betriebsbereichs zu betreiben.

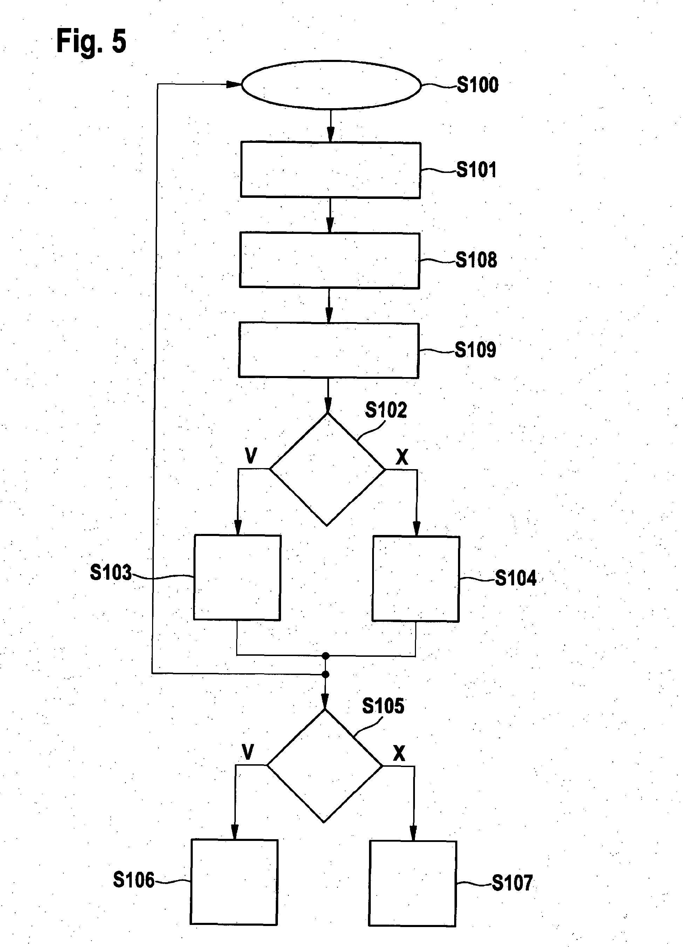

Figur 5 zeigt ein Blockschaltbild zur Bestimmung des zulässigen Betriebsbereichs von Betriebsparametern gemäß einer dritten Ausführungsvariante des erfindungsgemäßen Verfahrens, die eine Weiterbildung des in Figur 4 gezeigten Verfahrens darstellt.

Um die Genauigkeit des erfindungsgemäßen Verfahrens weiter zu erhöhen, ist es vorgesehen, die Grenzen des linearen Teilbereichs (das heißt des vordefinierten Vergleichsintervalls) in Verfahrensschritt S108 anhand der gemessenen Betriebsparameter V_{Batt}, I_{Batt}, T_{Batt} beziehungsweise der daraus ermittelten Parameter wie SOC und SOH zu bestimmen. Dabei ist es bevorzugt, diese Grenzen durch geeignete Algorithmen während des Betriebs anzupassen. Eine solche dynamische Anpassung der Grenzen ist beispielsweise vorteilhaft, da sich die zulässigen Betriebsbereiche der relevanten Betriebsparameter der Batterie 10 im Laufe der Zeit ändern können, wodurch sich auch der Teilbereich, in dem das Verhalten der Batterien 10 als linear angesehen werden kann, ändert. Verringert sich beispielsweise der lineare Teilbereich der oberen Temperaturgrenze, so wird eine Anpassung der Grenzen dazu führen, dass bereits bei geringeren Temperaturen auf die im Speicher 20 hinterlegten Daten (S104) anstatt auf das mathematische Batteriemodell (S103) zurückgegriffen wird, wobei die hinterlegten Daten in einem solchen Fall eine höhere Genauigkeit als das mathematische Batteriemodell aufweisen werden, da sich der Bereich, in dem das Verhalten der Batterie 10 als nichtlinear angesehen werden muss, im Laufe der Zeit vergrößert haben wird.

Um die,Genauigkeit des erfindungsgemäßen Verfahrens weiter zu erhöhen, ist es vorgesehen, in VerfahrensschrittS109 einen Abgleich zwischen den im Speicher 20 abgespeicherten Batteriedaten und den (durch das mathematische Batteriemodell bestimmten) zulässigen Betriebsbereichen der relevanten Betriebsparameter vorzunehmen.

Dieser Abgleich kann zum Beispiel anhand geeigneter Stützstellen im Betriebsbereich vollzogen werden. Dabei können zum Beispiel die empirischen Daten mittels geeigneter Gewichtungsfaktoren an die modellbasiert ermittelten Eigenschaften angepasst werden.

## Patentansprüche

1. Verfahren zur Ermittlung von Betriebsparametern einer Batterie (10), umfassend die Schritte:
- Messen (S100) von Betriebsparametern (V_{Batt}, I_{Batt}, T_{Batt}) der Batterie (10),
- Bestimmen (S101) weiterer Betriebsparameter (SOC, SOH) der Batterie (10) aus den gemessenen Betriebsparametern (V_{Batt}, I_{Batt}, T_{Batt}),
- Vergleich (S102) mindestens eines der bestimmten Betriebsparameter (SOC, SOH) mit einem vordefinierten Vergleichsintervall,
- Bestimmen (S103) eines zulässigen Betriebsbereichs des mindestens einen Betriebsparameters (SOC, SOH) allein anhand eines mathematischen Batteriemodells, sofern der mindestens eine Betriebsparameter (SOC, SOH) innerhalb des vordefinierten Vergleichsintervalls liegt, oder
- Bestimmen (S104) eines zulässigen Betriebsbereichs des mindestens einen Betriebsparameters (SOC, SOH) allein anhand abgespeicherter Batteriedaten, sofern der mindestens eine Betriebsparameter (SOC, SOH) außerhalb des vordefinierten Vergleichsintervalls liegt.

2. Verfahren nach Anspruch 1, wobei das Bestimmen (S103, S104) eines zulässigen Betriebsbereichs des mindestens einen Betriebsparameters (SOC, SOH) innerhalb eines vorgegebenen Zeitintervalls wiederholt wird.

3. Verfahren nach einem der vorhergehenden Ansprüche, wobei das mathematische Batteriemodell ein lineares mathematisches Batteriemodell ist.

4. Verfahren nach einem der vorhergehenden Ansprüche, wobei ein Vergleich (S105) des bestimmten zulässigen Betriebsbereichs des mindestens einen Betriebsparameters (SOC, SOH) mit einem Betriebsanforderungsprofil erfolgt, wobei die Batterie (10) gemäß dem Betriebsanforderungsprofil betrieben wird (S106), sofern der mindestens eine Betriebsparameter (SOC, SOH) des Betriebsanforderungsprofils innerhalb des zulässigen Betriebsbereichs liegt, oder die Batterie (10) gemäß einem Grenzwert des zulässigen Betriebsbereichs betrieben wird (S107), sofern der mindestens eine Betriebsparameter (SOC, SOH) des Betriebsanforderungsprofils außerhalb des zulässigen Betriebsbereichs liegt.

5. Verfahren nach einem der vorhergehenden Ansprüche, wobei das vordefinierte Vergleichsintervall anhand der gemessenen Betriebsparameter (V_{Batt}, I_{Batt}, T_{Batt}) bestimmt wird (S108).

6. Verfahren nach einem der vorhergehenden Ansprüche, wobei ein Abgleich (S109) zwischen den abgespeicherten Batteriedaten und dem mathematischen Batteriemodell vorgenommen wird.

7. Verfahren nach einem der vorhergehenden Ansprüche, wobei ein Betriebsparameter mindestens ein Element ausgewählt aus der Gruppe gebildet aus Ladezustand (SOC), Gesundheitszustand (SOH), Leistungsfähigkeit (SOF), obere und untere Spannungsgrenze, obere und untere Temperaturgrenze, obere und untere Stromgrenze, Ladeleistung, Entladeleistung, verfügbare Energie und entnehmbare Energie der Batterie (10) ist.

8. Batteriemanagementsystem umfassend:
- Mittel zum Messen (S100) von Betriebsparametern (V_{Batt}, I_{Batt}, T_{Batt}) der Batterie (10),
- Mittel (14) zum Bestimmen (S101) weiterer Betriebsparameter (SOC, SOH) der Batterie (10) aus den gemessenen Betriebsparametern (V_{Batt}, I_{Batt}, T_{Batt}),
- einen Speicher (20), in dem empirisch bestimmte Batteriedaten einer Batterie (10) über den Betriebsbereich abgespeichert sind,
**dadurch gekennzeichnet, dass**
das Batteriemanagementsystem ausgebildet ist, mindestens einen der bestimmten Betriebsparameter (SOC, SOH) mit einem vordefinierten Vergleichsintervall zu vergleichen, wobei der zulässige Betriebsbereich des mindestens einen Betriebsparameters (SOC, SOH) allein anhand eines mathematischen Batteriemodells bestimmt wird, sofern der mindestens eine Betriebsparameter (SOC, SOH) innerhalb des vordefinierten Vergleichsintervalls liegt oder der zulässige Betriebsbereich des mindestens einen Betriebsparameters (SOC, SOH) allein anhand abgespeicherter Batteriedaten bestimmt wird, sofern der mindestens eine Betriebsparameter (SOC, SOH) außerhalb des vordefinierten Vergleichsintervalls liegt.

9. Batterie, insbesondere eine Lithium-Ionen-Batterie, umfassend ein Batteriemanagementsystem nach Anspruch 8 und/oder ein Batteriemanagementsystem geeignet, ein Verfahren nach einem der Ansprüche 1 bis 7 auszuführen.

10. Kraftfahrzeug mit einer Batterie nach Anspruch 9, wobei die Batterie mit einem Antriebssystem des Kraftfahrzeuges verbunden ist.

## Claims

1. Method for ascertaining operating parameters of a battery (10), comprising the steps:
- measuring (S100) operating parameters (V_{Batt}, I_{Batt}, T_{Batt}) of the battery (10),
- determining (S101) further operating parameters (SOC, SOH) of the battery (10) from the measured operating parameters (V_{Batt}, I_{Batt}, T_{Batt}),
- comparing (S102) at least one of the determined operating parameters (SOC, SOH) with a predefined comparison interval,
- determining (S103) a permissible operating range of the at least one operating parameter (SOC, SOH) solely on the basis of a mathematical battery model insofar as the at least one operating parameter (SOC, SOH) lies within the predefined comparison interval, or
- determining (S104) a permissible operating range of the at least one operating parameter (SOC, SOH) solely on the basis of stored battery data insofar as the at least one operating parameter (SOC, SOH) is outside the predefined comparison interval.

2. Method according to Claim 1, wherein the determination (S103, S104) of a permissible operating range of the at least one operating parameter (SOC, SOH) is repeated within a predefined time interval.

3. Method according to one of the preceding claims, wherein the mathematical battery model is a linear mathematical battery model.

4. Method according to one of the preceding claims, wherein a comparison (S105) of the determined permissible operating range of the at least one operating parameter (SOC, SOH) with an operations request profile is carried out, wherein the battery (10) is operated (S106) according to the operations request profile insofar as the at least one operating parameter (SOC, SOH) of the operations request profile lies within the permissible operating range, or the battery (10) is operated (S107) according to a limiting value of the permissible operating range insofar as the at least one operating parameter (SOC, SOH) of the operations request profile lies outside the permissible operating range.

5. Method according to one of the preceding claims, wherein the predefined comparison interval is determined (S108) on the basis of the measured operating parameters (V_{Batt}, I_{Batt}, T_{Batt}).

6. Method according to one of the preceding claims, wherein reconciliation (S109) is carried out between the stored battery data and the mathematical battery model.

7. Method according to one of the preceding claims, wherein an operating parameter is at least one element selected from the group formed from the state of charge (SOC), state of health (SOH), state of function (SOF), upper and lower voltage limits, upper and lower temperature limits, upper and lower current limits, charging power, discharging power, available energy and energy which can be extracted from the battery (10).

8. Battery management system comprising:
- means for measuring (S100) operating parameters (V_{Batt}, I_{Batt}, T_{Batt}) of the battery (10),
- means (14) for determining (S101) further operating parameters (SOC, SOH) of the battery (10) from the measured operating parameters (V_{Batt}, I_{Batt}, T_{Batt}),
- a memory (20) in which empirically determined battery data of a battery (10) are stored over the operating range,
**characterized in that**
the battery management system is designed to compare at least one of the determined operating parameters (SOC, SOH) with a predefined comparison interval, wherein the permissible operating range of the at least one operating parameter (SOC, SOH) is determined solely on the basis of a mathematical battery model insofar as the at least one operating parameter (SOC, SOH) lies within the predefined comparison interval or the permissible operating range of the at least one operating parameter (SOC, SOH) is determined solely on the basis of stored battery data insofar as the at least one operating parameter (SOC, SOH) lies outside the predefined comparison interval.

9. Battery, in particular a lithium-ion battery, comprising a battery management system according to Claim 8, and/or a battery management system which is suitable for carrying out a method according to one of Claims 1 to 7.

10. Motor vehicle with a battery according to Claim 9, wherein the battery is connected to a drive system of the motor vehicle.

## Revendications

1. Procédé de détermination des paramètres de fonctionnement d'une batterie (10), comprenant les étapes suivantes :
- mesure (S100) de paramètres de fonctionnement (V_{Batt}, I_{Batt}, T_{Batt}) de la batterie (10),
- détermination (S101) de paramètres de fonctionnement supplémentaires (SOC, SOH) de la batterie (10) à partir des paramètres de fonctionnement (V_{Batt}, I_{Batt}, T_{Batt}) mesurés,
- comparaison (S102) d'au moins l'un des paramètres de fonctionnement (SOC, SOH) déterminés avec un intervalle de comparaison prédéfini,
- détermination (S103) d'une plage de fonctionnement admissible de l'au moins un paramètre de fonctionnement (SOC, SOH) uniquement au moyen d'un modèle de batterie mathématique, sous réserve que l'au moins un paramètre de fonctionnement (SOC, SOH) se trouve à l'intérieur de l'intervalle de comparaison prédéfini, ou
- détermination (S104) d'une plage de fonctionnement admissible de l'au moins un paramètre de fonctionnement (SOC, SOH) uniquement au moyen de données de batterie mémorisées, sous réserve que l'au moins un paramètre de fonctionnement (SOC, SOH) se trouve en dehors de l'intervalle de comparaison prédéfini.

2. Procédé selon la revendication 1, selon lequel la détermination (S103, S104) d'une plage de fonctionnement admissible de l'au moins un paramètre de fonctionnement (SOC, SOH) est répétée au sein d'un intervalle de temps prédéfini.

3. Procédé selon l'une des revendications précédentes, selon lequel le modèle de batterie mathématique est un modèle de batterie mathématique linéaire.

4. Procédé selon l'une des revendications précédentes, selon lequel une comparaison (S105) est effectuée de la plage de fonctionnement admissible déterminée de l'au moins un paramètre de fonctionnement (SOC, SOH) avec un profil d'exigence de fonctionnement, la batterie (10) étant exploitée (S106) conformément au profil d'exigence de fonctionnement sous réserve que l'au moins un paramètre de fonctionnement (SOC, SOH) du profil d'exigence de fonctionnement se trouve à l'intérieur de la plage de fonctionnement admissible, ou alors la batterie (10) étant exploitée (S107) conformément à une valeur limite de la plage de fonctionnement admissible sous réserve que l'au moins un paramètre de fonctionnement (SOC, SOH) du profil d'exigence de fonctionnement se trouve en dehors de la plage de fonctionnement admissible.

5. Procédé selon l'une des revendications précédentes, selon lequel l'intervalle de comparaison prédéfini est déterminé (S108) à l'aide des paramètres de fonctionnement (V_{Batt}, I_{Batt}, T_{Batt}) mesurés.

6. Procédé selon l'une des revendications précédentes, selon lequel une égalisation (S109) est effectuée entre les données de batterie mémorisées et le modèle de batterie mathématique.

7. Procédé selon l'une des revendications précédentes, selon lequel un paramètre de fonctionnement est au moins un élément choisi dans le groupe composé de l'état de charge (SOC), l'état de santé (SOH), la capacité de puissance (SOF), la limite de tension supérieure et inférieure, la limite de température supérieure et inférieure, la limite de courant supérieure et inférieure la puissance de charge, la puissance de décharge, l'énergie disponible et l'énergie prélevable de la batterie (10).

8. Système de gestion de batterie comprenant :
- des moyens pour mesurer (S100) des paramètres de fonctionnement (V_{Batt}, I_{Batt}, T_{Batt}) de la batterie (10),
- des moyens (14) pour déterminer (S101) des paramètres de fonctionnement supplémentaires (SOC, SOH) de la batterie (10) à partir des paramètres de fonctionnement (V_{Batt}, I_{Batt}, T_{Batt}) mesurés,
- une mémoire (20) dans laquelle sont mémorisées des données de batterie déterminées empiriquement d'une batterie (10) sur la plage de fonctionnement, **caractérisé en ce que**
le système de gestion de batterie est configuré pour comparer au moins l'un des paramètres de fonctionnement (SOC, SOH) déterminés avec un intervalle de comparaison prédéfini, la plage de fonctionnement admissible de l'au moins un paramètre de fonctionnement (SOC, SOH) étant déterminée uniquement au moyen d'un modèle de batterie mathématique, sous réserve que l'au moins un paramètre de fonctionnement (SOC, SOH) se trouve à l'intérieur de l'intervalle de comparaison prédéfini, ou la plage de fonctionnement admissible de l'au moins un paramètre de fonctionnement (SOC, SOH) étant déterminée uniquement au moyen de données de batterie mémorisées, sous réserve que l'au moins un paramètre de fonctionnement (SOC, SOH) se trouve en dehors de l'intervalle de comparaison prédéfini.

9. Batterie, notamment une batterie aux ions de lithium, comprenant un système de gestion de batterie selon la revendication 8 et/ou un système de gestion de batterie adapté pour mettre en oeuvre un procédé selon l'une des revendications 1 à 7.

10. Véhicule automobile équipé d'une batterie selon la revendication 9, la batterie étant reliée à un système de propulsion du véhicule automobile.
